**Europäisches Patentamt**

**European Patent Office**

**Office européen des brevets**

(19)

(11) Veröffentlichungsnummer: **0 025 169**
**B1**

(12) **EUROPÄISCHE PATENTSCHRIFT**

(45) Veröffentlichungstag der Patentschrift:
**03.08.88**

(51) Int. Cl.⁴: **G 11 C 19/28**, G 11 C 27/02

(21) Anmeldenummer: **80105058.4**

(22) Anmeldetag: **26.08.80**

(54) **Integrierte Schaltung mit zwei CTD-Anordnungen.**

(30) Priorität: **11.09.79 DE 2936731**

(43) Veröffentlichungstag der Anmeldung:
**18.03.81 Patentblatt 81/11**

(45) Bekanntmachung des Hinweises auf die Patenterteilung:
**03.08.88 Patentblatt 88/31**

(84) Benannte Vertragsstaaten:
**BE FR GB IT NL**

(56) Entgegenhaltungen:
EP - A - 0 019 506
DE - A - 2 348 245
DE - A - 2 644 593
DE - A - 2 736 326

1971 IEEE INTERNATIONAL SOLID-STATE CIRCUITS CONFERENCE, DIGEST OF TECHNICAL PAPERS, 17.-19. Februar 1971, Band 14, 1. Ausgabe, Seiten 162-163,203, Lewis Winner, New York, USA, W.F. KOSONOCKY et al.:" Charge-couples and carrier-domain devices"
IEEE TRANSACTIONS ON ELECTRON DEVICES, Band ED-23, no. 2, Februar 1976, Seiten 173-176, New York, USA, D.A. SEALER et al.:" A dual differential charge-coupled analog delay device"
SEQUIN & TOMPSETT: "CHARGE TRANSFER

(73) Patentinhaber: **Siemens Aktiengesellschaft Berlin und München, Witteisbacherplatz 2, D-8000 München 2 (DE)**

(72) Erfinder: **Pfleiderer, Hans-Jörg, Dr., Franz-Krinninger-Weg 23, D-8011 Zorneding (DE)**
Erfinder: **Klar, Heiner, Dr., Rossmarkt 8, D-8000 München 2 (DE)**

(56) Entgegenhaltungen: (Fortsetzung)
DEVICES, 1975, Seiten 52-61, Academic Press, New York, USA

**Beschreibung für die Vertragsstaaten: BE, FR, IT**

Die Erfindung bezieht sich auf eine integrierte Schaltung mit zwei CTD-Anordnungen nach dem Oberbegriff des Patentanspruchs 1.

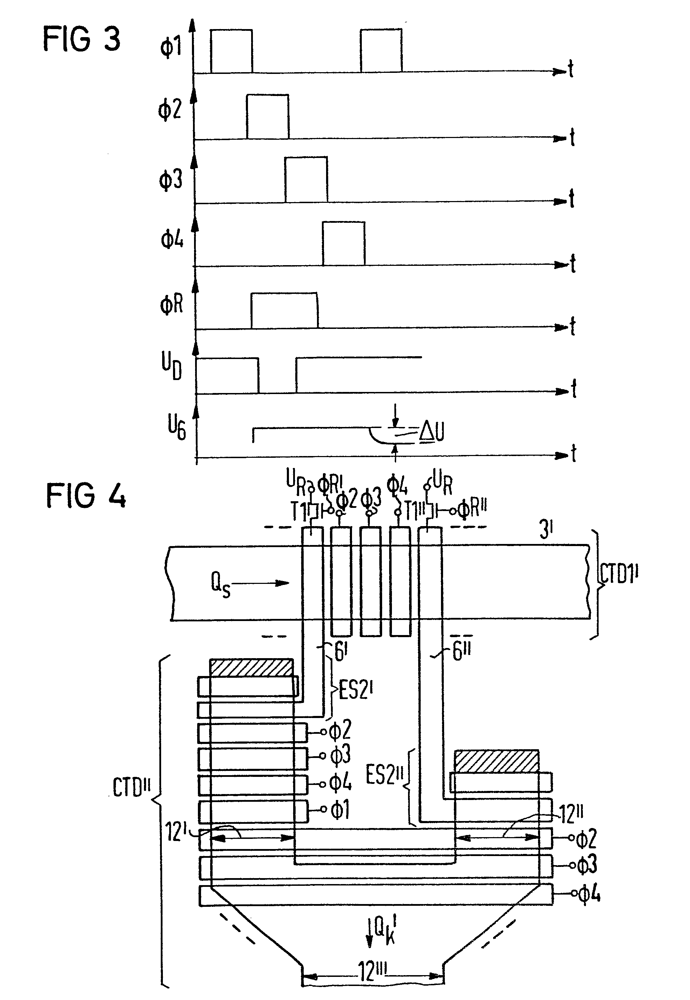

Eine Schaltung dieser Art ist aus dem Digest of Techn. Papers der IEEE International Solid-State Circuits Conf. 1971, Bd. 14, Febr. 1971, Seiten 162, 163 und 203, vgl. insbesondere Fig. 3 (b) bekannt. Hierbei ist die Referenzspannungsquelle während der Eingabe eines Ladungspaketes konstanter Grösse in die zweite CTD-Anordnung von dem rücksetzbaren Gate der ersten CTD-Anordnung getrennt. Weiterhin wird ein in der ersten CTD-Anordnung verschobenes, digitales Ladungspaket unter das von der Referenzspannungsquelle freigeschaltete, rückgesetzte Gate geschoben, bevor die genannte Eingabe eines Ladungspaketes konstanter Grösse in die zweite CTD-Anordnung erfolgt. Durch diese Massnahmen wird das in der ersten CTD-Anordnung verschobene, digitale Ladungspaket in einer komplementären Weise regeneriert. Im einzelnen wird zu diesem Zweck beim Auftreten eines digitalen Ladungspaketes in der ersten CTD-Anordnung die Weitergabe eines Ladungspaketes in der zweiten CTD-Anordnung am Ausgang der CTD-Eingangsstufe unterdrückt, während umgekehrt beim Fehlen eines Ladungspaketes in der ersten CTD-Anordnung die Weitergabe eines Ladungspaketes konstanter Grösse am Ausgang der CTD-Eingangsstufe zugelassen wird. Die in der zweiten CTD-Anordnung transportierten Ladungspakete stellen dann jeweils regenerierte, inverse, digitale Ladungspakete zu den in der ersten CTD-Anordnung transportierten Ladungspaketen dar.

Zur Umsetzung von Ladungspaketen, die in einer ersten CTD-Anordnung transportiert werden und analogen Signalwerten entsprechen, in Ladungspakete, die sich durch eine Subtraktion der genannten analogen Ladungspakete von Ladungspaketen konstanter Grösse ergeben, wird üblicherweise so vorgegangen, dass in einer CTD-Ausgangsstufe der ersten Anordnung von dem jeweils eintreffenden Ladungspaket ein Spannungssignal abgeleitet, invertiert und einer CTD-Eingangsstufe der zweiten Anordnung zugeführt wird, die dann aus dem Spannungssignal wieder ein Ladungspaket ableitet. Eine Schaltung, die dieser Funktion genügt, ist jedoch aufwendig und erfordert eine relativ grosse Halbleiterfläche.

Aus der DE-A-2 736 326 ist ferner ein CCD-Subtrahierer bekannt, bei dem die Differenz zwischen zwei aufeinanderfolgenden Ladungspaketen gebildet wird. Dies geschieht unter Zuhilfenahme einer schwimmenden Elektrode, die mit einer Bezugsspannung beaufschlagt wird, und einer mit dieser Elektrode verbundenen Kapazität, in der die eigentliche Differenzbildung stattfindet. Hier wird jedoch keine unmittelbare Subtraktion zweier Ladungspakete voneinander vorgenommen, sondern eine Subtraktion zweier diesen Ladungspaketen entsprechender Spannungen in der genannten Kapazität.

Der Erfindung liegt die Aufgabe zugrunde, eine integrierte Schaltung der eingangs genannten Art anzugeben, bei der in der ersten CTD-Anordnung transportierte Ladungspakete in komplementäre Ladungspakete umgesetzt werden, die dann in der zweiten CTD-Anordnung verschoben werden. Unter komplementären Ladungspaketen werden hierbei solche verstanden, die durch eine Subtraktion der in der ersten CTD-Anordnung transportierten Ladungspakete von Ladungspaketen konstanter Grösse gebildet werden. Diese Aufgabe wird durch eine Ausbildung der integrierten Schaltung nach dem kennzeichnenden Teil des Anspruchs 1 gelöst.

Der mit der Erfindung erzielbare Vorteil liegt insbesondere darin, dass zur Umsetzung der Ladungspakete in die komplementären nur ein geringer Schaltungsmehraufwand erforderlich ist, dass sich die gesamte Schaltung leicht auf einem dotierten Halbleiterkörper integrieren lässt und dass die Linearität der Umsetzung weitgehend gewährleistet ist.

Die Erfindung wird nachfolgend anhand der Zeichnung näher erläutert. Dabei zeigt:

Figur 1 eine Prinzipdarstellung eines Ausführungsbeispiels,

Figur 2 einen Querschnitt der Schaltung nach Figur 1,

Figur 3 Spannungs-Zeit-Diagramme zur Erläuterung von Figur 1, und

Figur 4 eine Weiterbildung der Schaltung nach Figur 1.

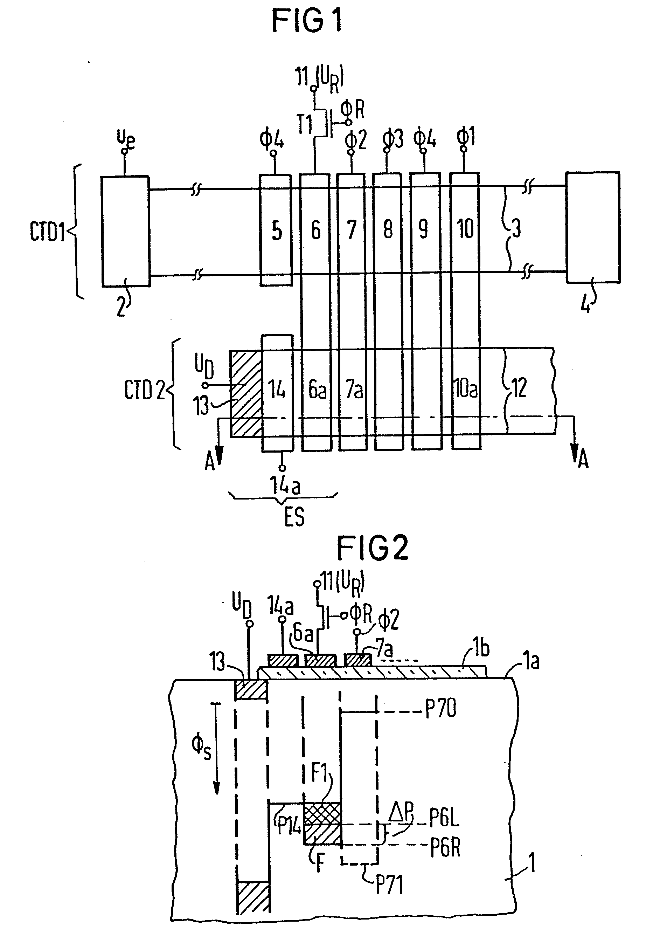

In Figur 1 ist auf einem dotierten Halbleiterkörper 1, z.B. aus p-leitendem Silizium, eine erste CTD-Anordnung integriert, die mit CTD1 bezeichnet ist. Sie besteht aus einer Eingangsstufe 2, einem durch die seitlichen Begrenzungen 3 definierten Übertragungskanal und einer Ausgangsstufe 4. Eine den Halbleiterkörper abdeckende isolierende Schicht, z.B. aus $SiO_2$, weist innerhalb der Linien 3 einen Dünnschichtbereich (Gateoxidbereich) auf, ausserhalb derselben einen Dickschichtbereich (Feldoxidbereich). Auf der isolierenden Schicht sind Transferelektroden 5 bis 10 angebracht, deren Anschlüsse mit Taktimpulsspannungen $\emptyset 1$ bis $\emptyset 4$ beschaltet sind. Die Transferelektrode 6 ist dabei nicht mit der Taktimpulsspannung $\emptyset 1$ belegt, sondern über einen Schalttransistor T1, dessen Gate an einer Taktimpulsspannung $\emptyset R$ liegt, mit einem an einer Referenzspannung $U_R$ liegenden Anschluss 11. Sie wird daher im folgenden als ein auf eine Referenzspannung rücksetzbares Glied bezeichnet. Da CTD1 im 4-Phasenbetrieb arbeitet, gehören jeweils vier nebeneinanderliegende Transferelektroden, die mit den Taktimpulsspannungen $\emptyset 1$ bis $\emptyset 4$ beschaltet sind, zu einer Transferstufe. Auch die Elektroden 6 bis 9 bilden eine solche.

Unterhalb von CTD1 ist eine zweite CTD-Anordnung CTD2 vorgesehen, die eine Eingangsstufe ES und einen durch seine lateralen Grenzen 12 dargestellten Übertragungskanal aufweist. Dieser Übertragungskanal ist ebenfalls mit einem Dünnschichtbereich der isolierenden Schicht überdeckt, der entlang der Grenzen 12 in einen Dickschichtbereich übergeht. Zu der Eingangsstufe ES gehört ein an der Grenzfläche von 1 angeordnetes Halbleitergebiet 13 mit einer zu 1 entgegengesetzten Leitfähigkeit, ein über seinen Anschluss 14a an einer Konstantspannung $U_B$ liegendes Gate 14 und ein Gate 6a, das aus den Kanal 12 überdeckenden Verlängerungen des Gate 6 besteht, oder auch aus einer mit 6 nicht zusammengefassten leitenden Belegung bestehen kann, die dann mit 6 über eine Leitung zu verbinden ist. Die Transferelektroden 7a bis 10a werden in Figur 1 wieder von der Verlängerung der Elektroden 7 bis 10 gebildet. Der in Figur 1 nicht dargestellte weitere Verlauf des Übertragungskanals 12 und die sich anschliessende Ausgangstufe sind für die Erläuterung der Erfindung nicht wesentlich.

Figur 2 zeigt einen Querschnitt durch die Anordnung nach Figur 1 entlang der Linie A–A. Ausserdem ist der Verlauf des Oberflächenpotentials $\emptyset_s$ auf der Linie A–A an der Grenzfläche 1a des Halbleiterkörpers nach unten aufgetragen.

Die Wirkungsweise der Anordnung nach Figur 1 sei im folgenden anhand der Figur 3 erläutert. Von der Eingangsstufe 2 wird ein Ladungspaket $Q_s$, das einem Abtastwert eines Eingangssignals $u_s$ entspricht, in den Übertragungskanal 3 eingegeben und von diesem unter dem Einfluss der Taktimpulsspannungen $\emptyset1$ bis $\emptyset4$ (Figur 3) in Richtung auf die Ausgangstufe 4 transportiert. Bevor es auf diesem Weg unter die Transferelektrode 5 gelangt, tritt ein Impuls $\emptyset R$ auf, der das Gate 6 auf die Spannung $U_R$ rücksetzt. An der Grenzfläche 1a tritt somit unterhalb von 6 ein Potential P6R auf. Unterhalb des Gate 14 besteht ein konstantes Oberflächenpotential P14. Zum Zeitpunkt t1 wird $U_D$ stark reduziert, so dass das Halbleitergebiet unterhalb der Gateelektroden 14 und 6a mit Ladungsträgern aus dem Gebiet 13 überschwemmt wird. Nach dem Wiederanstieg der Spannung $U_D$ bleibt die zwischen den Potentialschwellen P14 und P70 (unterhalb der Elektrode 7) befindliche Senke P6R mit einem Ladungspaket $Q_o$ gefüllt, wie in Figur 2 angedeutet ist. Dieses Ladungspaket entspricht der einfach schraffierten Fläche F und der doppelt schraffierten Fläche F1. Das Gate 6 liegt dabei auf der Spannung $U_R$. Mit der rückwärtigen Flanke 15 des Taktimpulses $\emptyset4$ gelangt nun das von 2 eingegebene Ladungspaket $Q_s$ unter das Gate 6 und bewirkt an diesem einen Spannungsabfall $\Delta U$, der unterhalb von 6a einen Potentialabfall $\Delta P$ auf P6L zur Folge hat. Dieser bewirkt eine Verdrängung der durch F1 gekennzeichneten Ladungsträger, die wieder in das Gebiet 13 zurückfliessen. Unterhalb von 6a bleibt also ein Ladungspaket $Q_K$ zurück, das der Fläche F entspricht. Dieses ist zu dem von 2 eingegebenen Ladungspaket $Q_s$ komplementär, da es der Beziehung $Q_K = Q_o - Q_s$ entspricht. Durch den folgenden Taktimpuls $\emptyset2$ und die weiteren Taktimpulse werden die Ladungspakete $Q_s$ in der Anordnung CTD1 und $Q_K$ in der Anordnung CTD2 schrittweise weitertransportiert.

Durch die feste Potentialschwelle P14, an der die Grösse des Ladungspaketes $Q_K$ eingestellt wird, können die Verarmungskapazitäten unterhalb von 6a und 6 die Linearität der Umsetzung von $Q_s$ auf $Q_K$ nicht beeinflussen.

Figur 4 zeigt eine Weiterbildung der Schaltung nach Figur 1, bei der von einer CTD-Anordnung mit einem im Übertragungskanal 3' transportierten Ladungspaket $Q_s$ ein verstärktes Ladungspaket $Q_K'$ abgeleitet wird, das in einer CTD-Anordnung CTD'' mit dem Übertragungskanal 12''' transportiert wird. Während in Figur 1 die Übertragungskanäle 3 und 12 im wesentlichen parallel zueinander verlaufen, ist der Übertragungskanal 12''' in Figur 3 senkrecht zu dem Übertragungskanal 3' angeordnet. Die Anordnung CTD'' weist zwei Eingangsstufe ES2' und ES2'' auf, die entsprechend der Stufe ES (Figur 1) aufgebaut sind und wie diese betrieben werden. Diese Stufen sind um die Länge einer Transferstufe von CTD'' in Längsrichtung gegeneinander versetzt. Den rücksetzbaren Gates 6' und 6'' wird die Spannung $U_R$ über Schalttransistoren T1' und T1'' zugeführt, wobei die Schalttransistoren mit Rücksetzimpulsen $\emptyset R'$ und $\emptyset R''$ beaufschlagt werden, die voneinander einen zeitlichen Abstand aufweisen, der einer Taktperiode von $\emptyset1$ entspricht. Unterhalb der Transferelektrode E von CTD'' werden die Übertragungskanäle 12' und 12'' zu einem gemeinsamen Kanal 12''' vereinigt. In diesem wird dann ein Ladungspaket $Q_K'$ transportiert, das etwa doppelt so gross ist wie das Ladungspaket $Q_K$ nach Figur 1.

Anstelle von zwei Eingangsstufen ES2' und ES2'' können auch mehrere vorgesehen sein, die dann mit den rücksetzbaren Gates entsprechend vieler CTD-Transferstufen von CTD1' verbunden sind.

Obwohl die bisher beschriebenen Ausführungsbeispiele von CTD-Anordnungen ausgehen, die als SCCD-Anordnungen (Surface Charge Coupled Device) ausgebildet sind, kann die Erfindung mit den bekannten CTD-Anordnungen beliebiger Art ausgeführt werden, wie sie beispielsweise in dem Buch von Séquin und Tompsett «Charge Transfer Devices», Academic Press, New York, 1975, auf den Seiten 1 bis 18 beschrieben sind. Diese CTD-Anordnungen können dabei entsprechend ihrem Aufbau im 2-, 3-, 4- oder Mehrphasenbetrieb arbeiten.

**Beschreibung für die Vertragsstaaten: GB, NL**

Die Erfindung bezieht sich auf eine integrierte Schaltung mit zwei CTD-Anordnungen nach dem Oberbegriff des Patentanspruchs 1.

Eine Schaltung dieser Art ist der EP-A-0 019 506, die gemäss Artikel 54(3) EPÜ zum Stand der Technik gehört, zu entnehmen.

Der Erfindung liegt die Aufgabe zugrunde, eine integrierte Schaltung der eingangs genannten Art anzugeben, bei der von einem in der ersten CTD-Anordnung transportierten, ersten Ladungspaket ein zweites, in der zweiten CTD-Anordnung transportiertes Ladungspaket abgeleitet wird, das sich aus dem ersten Ladungspaket dadurch ergibt, dass dieses von einem Ladungspaket konstanter Grösse subtrahiert wird, wobei das sich bei dieser Differenzbildung ergebende Ladungspaket noch zusätzlich verstärkt wird. Diese Aufgabe wird durch eine Ausbildung der integrierten Schaltung nach dem kennzeichnenden Teil des Patentanspruchs 1 gelöst.

Der mit der Erfindung erzielbare Vorteil liegt insbesondere darin, dass zur Umsetzung eines ersten Ladungspakets in ein zweites Ladungspaket nur ein geringer Schaltungsmehraufwand erforderlich ist, dass sich die gesamte Schaltung leicht auf einem dotierten Halbleiterkörper integrieren lässt und dass die Linearität der Umsetzung weitgehend gewährleistet ist.

Aus dem Digest of Techn. Papers der IEEE International Solid-State Circuits Conf. 1971, Bd. 14, Febr. 1971, Seiten 162, 163 und 203, vgl. insbesondere Figur 3 (b), ist eine integrierte Schaltung mit zwei CTD-Anordnungen bekannt, bei der die erste CTD-Anordnung ein über einen Schalttransistor mit einer Referenzspannungsquelle verbundenes, durch eine isolierende Schicht von der Grenzfläche des Halbleiterkörpers getrenntes, rücksetzbares Gate aufweist, das mit einem Gate der zweiten CTD-Anordnung elektrisch verbunden ist, und bei der das letztere Gate einen Bestandteil einer zur Eingabe von Ladungspaketen konstanter Grösse ausgebildeten CTD-Eingangsstufe der zweiten CTD-Anordnung bildet. Dabei wird beim Auftreten eines digitalen Ladungspaketes in der ersten CTD-Anordnung die Weitergabe eines Ladungspaketes in der zweiten CTD-Anordnung am Ausgang der CTD-Eingangsstufe unterdrückt, während umgekehrt beim Fehlen eines Ladungspaketes in der ersten CTD-Anordnung die Weitergabe eines Ladungspaketes konstanter Grösse am Ausgang der CTD-Eingangsstufe zugelassen wird. Die in der zweiten CTD-Anordnung transportierten Ladungspakete stellen dann jeweils regenerierte, inverse, digitale Ladungspakete zu den in der ersten CTD-Anordnung transportierten Ladungspaketen dar.

Aus der DE-A-2 736 326 ist ferner ein CCD-Subtrahierer bekannt, bei dem die Differenz zwischen zwei aufeinanderfolgenden Ladungspaketen gebildet wird. Dies geschieht unter Zuhilfenahme einer schwimmenden Elektrode, die mit einer Bezugsspannung beaufschlagt wird, und einer mit dieser Elektrode verbundenen Kapazität, in der die eigentliche Differenzbildung stattfindet. Hier wird jedoch keine unmittelbare Subtraktion zweier Ladungspakete voneinander vorgenommen, sondern eine Subtraktion zweier diesen Ladungspaketen entsprechender Spannungen in der genannten Kapazität.

Die Erfindung wird nachfolgend anhand der Zeichnung näher erläutert. Dabei zeigt:

Figur 1 eine Prinzipdarstellung einer bekannten Schaltung,

Figur 2 einen Querschnitt der Schaltung nach Figur 1,

Figur 3 Spannungs-Zeit-Diagramme zur Erläuterung von Figur 1, und

Figur 4 ein Ausführungsbeispiel der Erfindung.

In Figur 1 ist auf einem dotierten Halbleiterkörper 1, z.B. aus p-leitendem Silizium, eine erste CTD-Anordnung integriert, die mit CTD1 bezeichnet ist. Sie besteht aus einer Eingangsstufe 2, einem durch die seitlichen Begrenzungen 3 definierten Übertragungskanal und einer Ausgangsstufe 4. Eine den Halbleiterkörper abdeckende isolierende Schicht, z.B. aus $SiO_2$, weist innerhalb der Linien 3 einen Dünnschichtbereich (Gateoxidbereich) auf, ausserhalb derselben einen Dickschichtbereich (Feldoxidbereich). Auf der isolierenden Schicht sind Transferelektroden 5 bis 10 angebracht, deren Anschlüsse mit Taktimpulsspannungen $\emptyset1$ bis $\emptyset4$ beschaltet sind. Die Transferelektrode 6 ist dabei nicht mit der Taktimpulsspannung $\emptyset1$ belegt, sondern über einen Schalttransistor T1, dessen Gate an einer Taktimpulsspannung $\emptyset R$ liegt, mit einem an einer Referenzspannung $U_R$ liegenden Anschluss 11. Sie wird daher im folgenden als ein auf eine Referenzspannung rücksetzbares Glied bezeichnet. Da CTD1 im 4-Phasenbetrieb arbeitet, gehören jeweils vier nebeneinanderliegende Transferelektroden, die mit den Taktimpulsspannungen $\emptyset1$ bis $\emptyset4$ beschaltet sind, zu einer Transferstufe. Auch die Elektroden 6 bis 9 bilden eine solche.

Unterhalb von CTD1 ist eine zweite CTD-Anordnung CTD2 vorgesehen, die eine Eingangsstufe ES und einen durch seine lateralen Grenzen 12 dargestellten Übertragungskanal aufweist. Dieser Übertragungskanal ist ebenfalls mit einem Dünnschichtbereich der isolierenden Schicht überdeckt, der entlang der Grenzen 12 in einen Dickschichtbereich übergeht. Zu der Eingangsstufe ES gehört ein an der Grenzfläche von 1 angeordnetes Halbleitergebiet 13 mit einer zu 1 entgegengesetzten Leitfähigkeit, ein über seinen Anschluss 14a an einer Konstantspannung $U_B$ liegendes Gate 14 und ein Gate 6a, das aus den Kanal 12 überdeckenden Verlängerungen des Gate 6 besteht, oder auch aus einer mit 6 nicht zusammengefassten leitenden Belegung bestehen kann, die dann mit 6 über eine Leitung zu verbinden ist. Die Transferelektroden 7a bis 10a werden in Figur 1 wieder von der Verlängerung der Elektroden 7 bis 10 gebildet. Der in Figur 1 nicht dargestellte weitere Verlauf des Übertragungskanals 12 und die sich anschliessende Ausgangstufe sind für die Erläuterung der Erfindung nicht wesentlich.

Figur 2 zeigt einen Querschnitt durch die Anordnung nach Figur 1 entlang der Linie A–A. Ausserdem ist der Verlauf des Oberflächenpotentials $\emptyset_s$ auf der Linie A–A an der Grenzfläche 1a des Halbleiterkörpers nach unten aufgetragen.

Die Wirkungsweise der Anordnung nach Figur 1 sei im folgenden anhand der Figur 3 erläutert. Von der Eingangsstufe 2 wird ein Ladungspaket $Q_s$, das einem Abtastwert eines Eingangssignals $u_s$ entspricht, in den Übertragungskanal 3 eingegeben und von diesem unter dem Einfluss der Taktimpulsspannungen $\emptyset1$ bis $\emptyset4$ (Figur 3) in Richtung auf die Ausgangsstufe 4 transportiert. Bevor es auf diesem Weg unter die Transferelektrode 5 gelangt, tritt ein Impuls $\emptyset R$ auf, der das Gate 6 auf die Spannung $U_R$ rücksetzt. An der Grenzfläche 1a tritt somit unterhalb von 6 ein Potential P6R auf. Unterhalb des Gate 14 besteht ein konstantes Oberflächenpotential P14. Zum Zeitpunkt t1 wird $U_D$ stark reduziert, so dass das Halbleitergebiet unterhalb der Gateelektroden 14 und 6a mit Ladungsträgern aus dem Gebiet 13 überschwemmt wird. Nach dem Wiederanstieg der Spannung $U_D$ bleibt die zwischen den Potentialschwellen P14 und P70 (unterhalb der Elektrode 7) befindliche Senke P6R mit einem Ladungspaket $Q_o$ gefüllt, wie in Figur 2 angedeutet ist. Dieses Ladungspaket entspricht der einfach schraffierten Fläche F und der doppelt schraffierten Fläche F1. Das Gate 6 liegt dabei auf der Spannung $U_R$. Mit der rückwärtigen Flanke 15 des Taktimpulses $\emptyset 4$ gelangt nun das von 2 eingegebene Ladungspaket $Q_s$ unter das Gate 6 und bewirkt an diesem einen Spannungsabfall $\Delta U$, der unterhalb von 6a einen Potentialabfall $\Delta P$ auf P6L zur Folge hat. Dieser bewirkt eine Verdrängung der durch F1 gekennzeichneten Ladungsträger, die wieder in das Gebiet 13 zurückfliessen. Unterhalb von 6a bleibt also ein Ladungspaket $Q_K$ zurück, das der Fläche F entspricht. Dieses ist zu dem von 2 eingegebenen Ladungspaket $Q_s$ komplementär, da es der Beziehung $Q_K = Q_o - Q_s$ entspricht. Durch den folgenden Taktimpuls $\emptyset 2$ und die weiteren Taktimpulse werden die Ladungspakete $Q_s$ in der Anordnung CTD1 und $Q_K$ in der Anordnung CTD2 schrittweise weitertransportiert.

Durch die feste Potentialschwelle P14, an der die Grösse des Ladungspaketes $Q_K$ eingestellt wird, können die Verarmungskapazitäten unterhalb von 6a und 6 die Linearität der Umsetzung von $Q_s$ auf $Q_K$ nicht beeinflussen.

Figur 4 zeigt ein Ausführungsbeispiel der Erfindung, das von einer Schaltung nach Figur 1 ausgeht. Hier wird von einer CTD-Anordnung mit einem im Übertragungskanal 3' transportierten Ladungspaket $Q_s$ ein verstärktes Ladungspaket $Q_K'$ abgeleitet, das in einer CTD-Anordnung CTD'' mit dem Übertragungskanal 12''' transportiert wird. Während in Figur 1 die Übertragungskanäle 3 und 12 im wesentlichen parallel zueinander verlaufen, ist der Übertragungskanal 12''' in Figur 3 senkrecht zu dem Übertragungskanal 3' angeordnet. Die Anordnung CTD'' weist zwei Eingangsstufe ES2' und ES2'' auf, die entsprechend der Stufe ES (Figur 1) aufgebaut sind und wie diese betrieben werden. Diese Stufen sind um die Länge einer Transferstufe von CTD'' in Längsrichtung gegeneinander versetzt. Den rücksetzbaren Gates 6' und 6'' wird die Spannung $U_R$ über Schalttransistoren T1' und T1'' zugeführt, wobei die Schalttransistoren mit Rücksetzimpulsen $\emptyset R'$ und $\emptyset R''$ beaufschlagt werden, die voneinander einen zeitlichen Abstand aufweisen, der einer Taktperiode von $\emptyset 1$ entspricht. Unterhalb der Transferelektrode E von CTD'' werden die Übertragungskanäle 12' und 12'' zu einem gemeinsamen Kanal 12''' vereinigt. In diesem wird dann ein Ladungspaket $Q_K'$ transportiert, das etwa doppelt so gross ist wie das Ladungspaket $Q_K$ nach Figur 1.

Anstelle von zwei Eingangsstufen ES2' und ES2'' können auch mehrere vorgesehen sein, die dann mit den rücksetzbaren Gates entsprechend vieler CTD-Transferstufen von CTD1' verbunden sind.

Obwohl das vorstehend beschriebene Ausführungsbeispiel von einer CTD-Anordnung ausgeht, die als SCCD-Anordnung (Surface Charge Coupled Device) ausgebildet ist, kann die Erfindung mit den bekannten CTD-Anordnungen beliebiger Art ausgeführt werden, wie sie beispielsweise in dem Buch von Séquin und Tompsett «Charge Transfer Devices», Academic Press, New York, 1975, auf den Seiten 1 bis 18 beschrieben sind. Diese CTD-Anordnungen können dabei entsprechend ihrem Aufbau im 2-, 3-, 4- oder Mehrphasenbetrieb arbeiten.

**Patentansprüche für die Vertragsstaaten: BE, FR und IT**

1. Integrierte Schaltung mit zwei CTD-Anordnungen auf einem dotierten Halbleiterkörper, bei der die erste CTD-Anordnung (CTD1) ein über einen Schalttransistor (T1) mit einer Referenzspannungsquelle ($U_R$) verbundenes, durch eine isolierende Schicht (1b) von der Grenzfläche (1a) des Halbleiterkörpers (1) getrenntes, rücksetzbares Gate (6) aufweist, das mit einem Gate (6a) der zweiten CTD-Anordnung (CTD2) elektrisch verbunden ist, und bei der das letztere Gate (6a) einen Bestandteil einer zur Eingabe von Ladungspaketen konstanter Grösse ($Q_O$) ausgebildeten CTD-Eingangsstufe (ES) der zweiten CTD-Anordnung (CTD2) bildet, dadurch gekennzeichnet, dass zur Erzeugung von Ladungspaketen ($Q_K$), die sich durch eine Subtraktion der in der ersten CTD-Anordnung transportierten Ladungspakete ($Q_s$) von den Ladungspaketen konstanter Grösse ($Q_O$) ergeben und in der zweiten CTD-Anordnung transportiert werden, die Referenzspannungsquelle ($U_R$) während der Eingabe eines Ladungspaketes konstanter Grösse ($Q_O$) in die CTD-Eingangsstufe (ES) mit dem rücksetzbaren Gate (6) verbunden ist und dass die Referenzspannungsquelle ($U_R$) während des sich anschliessenden Transports eines in der ersten CTD-Anordnung verschobenen Ladungspaketes ($Q_s$) unter das rücksetzbare Gate (6) von diesem abgeschaltet ist.

2. Integrierte Schaltung nach Anspruch 1, dadurch gekennzeichnet, dass die Übertragungskanäle (3, 12) beider CTD-Anordnungen (CTD1, CTD2) gemeinsam von streifenförmigen, leitenden Belegungen (6 ... 10) überdeckt sind, die durch eine isolierende Schicht (1b) von der Grenzfläche (1a) des Halbleiterkörpers (1) getrennt sind und die rücksetzbaren Gates (6, 6a) sowie die Transferelektroden (7 ... 10) beider CTD-Anordnungen darstellen.

3. Integrierte Schaltung nach Anspruch 1, dadurch gekennzeichnet, dass die erste CTD-Anordnung (CTD1) zwei oder mehrere rücksetzbare Gates (6', 6'') in Abständen von einer oder mehreren Transferstufen aufweist, die jeweils mit rücksetzbaren Gates von einer zweiten CTD-Anordnung (CTD2') verbunden sind, dass die letztgenannten Gates jeweils Bestandteile von zur Eingabe von Ladungspaketen konstanter Grösse ausgebildeten CTD-Eingangsstufen (ES2', ES2'') darstellen und dass den Eingangsstufen Teile (12', 12'') des Übertragungskanals (12''') der zweiten CTD-Anordnung (CTD2') nachgeschaltet sind, die sich zu einem gemeinsamen Übertragungskanal (12''') vereinigen.

### Patentanspruch für die Vertragsstaaten: GB und NL

1. Integrierte Schaltung mit zwei CTD-Anordnungen auf einem dotierten Halbleiterkörper, bei der die erste CTD-Anordnung (CTD1') ein über einen Schalttransistor (T1') mit einer Referenzspannungsquelle ($U_R$) verbundenes, durch eine isolierende Schicht (1b) von der Grenzfläche (1a) des Halbleiterkörpers (1) getrenntes, rücksetzbares Gate (6') aufweist, das mit einem Gate (6a) der zweiten CTD-Anordnung (CTD'') elektrisch verbunden ist, und bei der das letztere Gate (6a) einen Bestandteil einer zur Eingabe von Ladungspaketen konstanter Grösse ($Q_O$) ausgebildeten CTD-Eingangsstufe (ES2') der zweiten CTD-Anordnung (CTD'') bildet, bei der zur Erzeugung von Ladungspaketen ($Q_K$), die sich durch eine Subtraktion der in der ersten CTD-Anordnung transportierten Ladungspakete ($Q_s$) von den Ladungspaketen konstanter Grösse ($Q_O$) ergeben und in der zweiten CTD-Anordnung transportiert werden, die Referenzspannungsquelle ($U_R$) während der Eingabe eines Ladungspaketes konstanter Grösse ($Q_O$) in die CTD-Eingangsstufe (ES2') mit dem rücksetzbaren Gate (6) verbunden ist und bei der die Referenzspannungsquelle ($U_R$) während des sich anschliessenden Transports eines in der ersten CTD-Anordnung verschobenen Ladungspaketes ($Q_s$) unter das rücksetzbare Gate (6) von diesem abgeschaltet ist, dadurch gekennzeichnet, dass die erste CTD-Anordnung (CTD1') zwei oder mehrere rücksetzbare Gates (6', 6'') in Abständen von einer oder mehreren Transferstufen aufweist, die jeweils mit rücksetzbaren Gates der zweiten CTD-Anordnung (CTD'') verbunden sind, dass die letztgenannten Gates jeweils Bestandteile von zur Eingabe von Ladungspaketen konstanter Grösse ausgebildeten CTD-Eingangsstufen (ES2', ES2'') darstellen und dass diesen Eingangsstufen (12', 12'') Teile des Übertragungskanals (12''') der zweiten CTD-Anordnung (CTD'') nachgeschaltet sind, die sich zu einem gemeinsamen Übertragungskanal (12''') vereinigen.

### Claims for the contracting States: BE, FR and IT

1. An integrated circuit comprising two CTD-arrangements on a doped semiconductor body, in which the first CTD-arrangement (CTD1) includes a resettable gate (6) which is connected to a reference voltage source ($U_R$) via a switching transistor (T1), is separated from the boundary surface (1a) of the semiconductor body (1) by an insulating layer (1b), and is electrically-connected to a gate (6a) of the second CTD-arrangement (CTD2), and where the latter gate (6a) forms part of a CTD-input stage (ES) of the second CTD-arrangement (CTD2) which serves to input charge packets of constant size ($Q_O$) for the formation of charge packets ($Q_K$) which are formed by subtracting the charge packets ($Q_s$) transported in the first CTD-arrangement from the charge packets of constant size ($Q_O$), characterised in that for the formation of charge packets ($Q_K$) which are formed by subtracting the charge packets ($Q_s$) transported in the first CTD-arrangement from the charge packets of constant size ($Q_O$) and which are transported in the second CTD-arrangement, during the input of a charge packet of constant size ($Q_O$) into the CTD-input stage (ES), the reference voltage source ($U_R$) is connected to the resettable gate (6), and that, during the subsequent transportation of a charge packet ($Q_s$) displaced in the first CTD-arrangement, beneath the resettable gate (6), the reference voltage source ($U_R$) is disconnected from the resettable gate.

2. An integrated circuit as claimed in Claim 1, characterised in that the transfer channels (3, 12) of the two CTD-arrangements (CTD1, CTD2) are commonly covered by strip-like conductive coatings (6 . . . 10) which are separated by an insulating layer (1b) from the boundary surface (1a) of the semiconductor body (1) and which represent the resettable gates (6, 6a) and the transfer electrodes (7 . . . 10) of the two CTD-arrangements.

3. An integrated circuit as claimed in Claim 1, characterised in that the first CTD-arrangement (CTD1) comprises two or more resettable gates (6', 6'') which are arranged at intervals of one or more transfer stages and which are each connected to resettable gates of a second CTD-arrangement (CTD2'), that the last-mentioned gates each represent parts of CTD-input stages (ES2', ES2'') which serve to input charge packets of constant size, and that the input stages are connected at their output to parts (12', 12'') of the transmission channel (12''') of the second CTD-arrangement (CTD2') which are combined to form a common transmission channel (12''').

### Claim for the contracting States: UK and NL

1. An integrated circuit comprising two CTD-arrangements on a doped semiconductor body, in which the first CTD-arrangement (CTD1) includes a resettable gate (6') which is connected to a reference voltage source ($U_R$) via a switching transistor (T1'), is separated from the boundary surface (1a) of the semiconductor body (1) by an insulating layer (1b), and is electrically-connected to a gate (6a) of the second CTD-arrangement (CTD''), and where the latter gate (6a) forms part of a CTD-input stage (ES2') of the second CTD-arrangement (CTD'') which serves to input charge packets of constant size ($Q_O$) for the formation of charge packets ($Q_K$) which are formed by subtracting the charge packets ($Q_s$) transported in the first CTD-arrangement from the charge packets of constant size ($Q_O$) and are transported in the second CTD-arrangement, during the input of a charge packet of constant size ($Q_O$) into the CTD-input stage (ES2'), the reference voltage source ($U_R$) is connected to the resettable gate (6), and during the subsequent transportation of a charge packet ($Q_S$), which is displaced in the first CTD-arrangement, beneath the resettable gate (6), the reference voltage source ($U_R$) is disconnected from the resettable gate, characterised in that the first CTD-arrangement (CTD1') comprises two or more resettable gates (6', 6'') which are arranged at intervals of one or more transfer stages and which are each connected to resettable gates of the second CTD-arrangement (CTD''), that the last-mentioned gates each represent parts of CTD-input stages (ES2', ES2'') which serve to input charge packets of constant size, and that these input stages (12', 12'') are connected at their output end to parts of the transfer channel (12''') of the second CTD-arrangement (CTD'') which are combined to form a common transfer channel (12''').

**Revendications pour les Etats contractants: BE, FR, IT**

1. Circuit intégré comportant deux dispositifs CTD situés sur un coprs semiconducteurs dopé et dans lequel le premier dispositif CTD (CTD1) comporte une grille (6) pouvant être ramenée à l'état initial, qui est reliée par l'intermédiaire d'un transistor de commutation (T1) à une source de tension de référence $U_R$, est séparée de la surface limite (10a) du corps semiconducteur (1) par une couche isolante (1b) et est raccordée électriquement à une grille (6a) du second dispositif CTD (CTD2), et dans lequel la dernière grille (6a) fait partie d'un étage d'entrée CTD (ES), agencé pour réaliser l'introduction de paquets de charges de valeur constante ($Q_O$), du second dispositif CTD (CTD2), caractérisé par le fait que pour la production de paquets de charge ($Q_K$), qui sont obtenus par soustraction des paquets de charge ($Q_S$) transportés à l'intérieur du premier dispositif CTD, des paquets de charge de valeur constante ($Q_O$) et sont transportés à l'intérieur du second dispositif CTD, la source de tension de référence ($U_R$) est reliée à la grille (6) pouvant être ramenée à l'état initial, pendant l'introduction d'un paquet de charge de valeur constante ($Q_O$) dans l'étage d'entrée CTD (ES), et que la source de tension de référence ($U_R$) est déconnectée de la grille (6) pouvant être ramenée à l'état initial, pendant le transfert suivant d'un premier paquet de charges ($Q_S$), déplacé à l'intérieur du premier dispositif CTD, au-dessous de ladite grille.

2. Circuit intégré suivant la revendication 1, caractérisé par le fait que les canaux de transfert (3, 12) des deux dispositifs CTD (CTD1, CTD2) sont recouverts en commun par des revêtements conducteurs en forme de bandes (6 ... 10), qui sont séparés de la surface limite (1a) du corps semiconducteur (1) par une couche isolante (1b) et représentent les grilles (6, 6a), pouvant être ramenées à l'état initial, ainsi que les électrodes de transfert (7 ... 10) des deux dispositifs CTD.

3. Circuit intégré suivant la revendication 1, caractérisé par le fait que le premier dispositif CTD (CTD1) comporte deux ou plusieurs grilles (6', 6'') pouvant être ramenées à l'état initial, qui sont situées à distance d'un ou de plusieurs étages de transfert et sont reliées respectivement à des grilles, pouvant être ramenées à l'état initial, d'un second dispositif CTD (CTD2'), que les grilles indiquées en dernier lieu font partie respectivement d'étages d'entrée CTD (ES2', ES2'') agencés pour l'introduction de paquets de charge possédant une valeur constante, et qu'en aval des étages d'entrée sont branchées, des parties (12', 12''), du canal de transmission (12''') du second dispositif CTD (CTD2'), qui se rejoignent pour former un canal commun de transmission (12''').

**Revendication pour les Etats contractants: GB, NL**

1. Circuit intégré comportant deux dispositifs CTD situés sur un corps semiconducteur dopé et dans lequel le premier dispositif CTD (CTD1') comporte une grille (6') pouvant être ramenée à l'état initial, qui est reliée par l'intermédiaire d'un transistor de commutation (T1') à une source de tension de référence ($U_R$), est séparée de la surface limite (1a) du corps semiconducteur (1) par une couche isolante (1b) et est raccordée électriquement à une grille (6a) du second dispositif CTD (CTD''), et dans lequel la dernière grille (6a) fait partie d'un étage d'entrée CTD (ES2'), agencé pour réaliser l'introduction de paquets de charges de valeur constante ($Q_O$), du second dispositif CTD (CTD''), et dans lequel, pour la production de paquets de charges ($Q_K$), qui sont obtenus par soustraction des paquets de charges ($Q_S$) transportés à l'intérieur du premier dispositif CTD, des paquets de charges de valeur constante ($Q_O$) et sont transportés à l'intérieur du second dispositif CTD, la source de tension de référence ($U_R$) est reliée à la grille (6) pouvant être ramenée à l'état initial, pendant l'introduction d'un paquet de charges de valeur constante ($Q_O$) dans l'étage d'entrée CTD (ES2'), et dans lequel la source de tension de référence ($U_R$) est déconnectée de la grille (6) pouvant être ramenée à l'état initial, pendant le transfert suivant d'un premier paquet de charges ($Q_S$), déplacé à l'intérieur du premier dispositif CTD, au-dessous de ladite grille, caractérisé par le fait que le premier dispositif CTD (CTD1') comporte deux ou plusieurs grilles (6', 6'') pouvant être ramenées à l'état initial, qui sont situées à distance d'un ou de plusieurs étages de transfert et sont reliées respectivement à des grilles, pouvant être ramenées à l'état initial, d'un second dispositif CTD (CTD''), que les grilles indiquées en dernier lieu font partie respectivement d'étages d'entrée CTD (ES2', ES2''), et qu'en aval de ces étages d'entrée sont branchées des parties (12', 12'') du canal de transmission (12''') du second dispositif CTD (CTD''), qui se rejoignent pour former un canal commun de transmission (12''').

# FIG 1

11 (U_R)

ΦR

T1

U_e

Φ4   Φ2  Φ3  Φ4  Φ1

CTD1

| 5 | 6 | 7 | 8 | 9 | 10 |

3

2

4

CTD 2

U_D

13

| 14 | 6a | 7a | | 10a | 12 |

A

14a

ES

A

# FIG 2

11 (U_R)

U_D  14a

6a

ΦR  Φ2

7a   1b   1a

13

Φ_S

P70

F1

P14  ΔP  P6L

P6R

F

P71

1

9

FIG 3

FIG 4